# EUROPEAN PATENT APPLICATION

(11) **EP 4 546 327 A1**
(43) Date of publication of application: **30.04.2025**
(21) Application number: 23854366.4
(22) Date of filing: 11.08.2023
(51) Int. Cl.: G09G 3/3225

(54) **DISPLAY DRIVING CHIP, DISPLAY SCREEN AND DISPLAY APPARATUS**

(30) Priority: 19.08.2022 CN 202210998621; 22.02.2023 CN 202310184145
(71) Applicant: Huawei Technologies Co., Ltd., Shenzhen, Guangdong 518129 (CN)
(72) Inventor: HUANG, Huaqiang, Shenzhen, Guangdong 518129 (CN); MU, Tengfei, Shenzhen, Guangdong 518129 (CN); GUO, Chunlei, Shenzhen, Guangdong 518129 (CN); JIANG, Congbiao, Shenzhen, Guangdong 518129 (CN)
(74) Representative: Pfenning, Meinig & Partner mbB
(86) International application number: PCT/CN2023/112689
(87) International publication number: WO 2024/037465

(57) **Abstract**

Embodiments of this application disclose a display drive chip, a display, and a display apparatus. The display apparatus includes the display drive chip and the display, and the display drive chip is configured to drive the display. Based on a structure of a conventional display apparatus, a time sequence gating circuit is added to the display drive chip, and a time sequence switch circuit is added to the display. The time sequence gating circuit of the display drive chip can provide a gating signal for the time sequence switch circuit of the display. The time sequence switch circuit of the display may connect or disconnect a time sequence drive circuit to/from a plurality of gate lines of the display based on the gating signal, to flexibly control a partially refreshed area. A size of a partially refreshed image can be adaptively adapted to without adding a plurality of sets of GOAs, to implement precise partial refresh display of the display, and no additional waste of power consumption is generated.

## Description

### CROSS-REFERENCE TO RELATED APPLICATIONS

This application claims priorities to Chinese Patent Application 202210998621.8, filed with the China National Intellectual Property Administration on August 19, 2022 and entitled "DISPLAY DRIVE CIRCUIT", and to Chinese Patent Application No. 202310184145.0, filed with the China National Intellectual Property Administration on February 22, 2023 and entitled "DISPLAY DRIVE CHIP, DISPLAY, AND DISPLAY APPARATUS", both of which are incorporated herein by reference in their entireties.

### TECHNICAL FIELD

This application relates to the field of display technologies, and in particular, to a display drive chip, a display, and a display apparatus.

### BACKGROUND

Currently, in a process of using an electronic product, only a part of content needs to be refreshed (namely, partial refresh) for display sometimes. For example, each time a page is turned, reading software only refreshes a middle part of content for display, and keeps content on a surrounding frame unchanged. Currently, most displays do not support partial refresh. When a small refreshed area is required, full-screen refresh consumes high power.

### SUMMARY

Because a drive chip of a display needs to perform algorithm processing and drive display on a picture that is not refreshed, if an area that is not refreshed is large, a large amount of power is consumed. This application needs to resolve problems in the conventional technology, such as inflexible partial refresh, waste of extra power consumption caused by cross-area splicing display, and possible increasing of the power consumption without decreasing.

This application provides a display drive chip, a display, and a display apparatus, to implement flexible partial refresh display.

According to a first aspect, this application provides a display drive chip. The display drive chip is configured to drive a display, and the display drive chip may specifically include a time sequence control circuit and a time sequence gating circuit. The time sequence control circuit is configured to provide a drive signal for a time sequence drive circuit of the display. Specifically, the time sequence control circuit may generate a frame start signal as the drive signal, to trigger the time sequence drive circuit of the display to start to output scanning signals level by level. The time sequence gating circuit is configured to provide a gating signal for a time sequence switch circuit of the display. Specifically, the time sequence gating circuit may generate the corresponding gating signal based on a received partially refreshed image, and send the gating signal to the time sequence switch circuit of the display. The time sequence switch circuit connects or disconnects the time sequence drive circuit and a plurality of gate lines based on the gating signal. In other words, the time sequence switch circuit may transmit a scanning signal corresponding to the partially refreshed image.

Further, the display drive chip may further include a channel drive circuit. The channel drive circuit is configured to separately provide a data signal for a plurality of data lines of the display.

The time sequence switch circuit of the display drive chip provided in this embodiment of this application can generate the corresponding gating signal based on the partially refreshed image, so that the time sequence switch circuit of the display connects or disconnects the time sequence drive circuit and a plurality of gate lines based on the gating signal. In other words, the time sequence switch circuit may send, based on the gating signal, the scanning signal corresponding to the partially refreshed image, to a corresponding pixel circuit for refreshing and display, so that a partially refreshed area can be flexibly controlled.

In an embodiment of this application, the channel drive circuit of the display drive chip may generate only a data signal corresponding to the partially refreshed image, that is, perform algorithm processing and driving only on the partially refreshed image, so that power consumption of the display drive chip can be effectively reduced.

In an embodiment of this application, the channel drive circuit may directly process invalid line data other than the partially refreshed image into a vertical blanking area, to disable channel drive and reduce power consumption. In this way, the display drive chip does not need to perform algorithm processing and driving on the invalid data, so that power consumption can be reduced.

In an embodiment of this application, the time sequence gating circuit of the display drive chip may generate a line-level selection signal (line select) as the gating signal by using a line of pixel circuits of the display as a unit, and notify the display to implement line-level partial refresh by using the line of pixel circuits as the unit. In other words, the line of pixel circuits of the display is used as a whole to refresh and display or keep content unchanged. For example, it is assumed that an image that needs to be refreshed for display is a rectangle, coordinates of the partially refreshed image received by the display drive chip are (x1, y1) to (x2, y2), (x1, y1) are coordinates of an upper left corner of the image that needs to be refreshed for display, and (x2, y2) are coordinates of a lower right corner of the image that needs to be refreshed. In this case, the line-level selection signal generated by the time sequence gating circuit based on x1 and x2 is the gating signal that is in a scanning time period corresponding to lines x1 to x2 and that allows the scanning signal to pass through. Specifically, the channel drive circuit of the display drive chip transmits the generated data signals to the display area in the display in a line level. The time sequence control circuit of the display drive chip sends the frame start signal to the display, to trigger the time sequence drive circuit to start to output the scanning signals line by line. After generating the line-level selection signal, the time sequence gating circuit of the display drive chip notifies the time sequence switch circuit of the display to perform line-level partial refresh. The time sequence switch circuit shields, based on the received line-level selection signal, a scanning signal of an invalid line other than the partially refreshed image, and transmits only a scanning signal of a line that needs to be refreshed. After receiving the scanning signal, the pixel circuit that needs to refresh the line refreshes display content based on the data signal, to complete partial refresh display.

According to a second aspect, this application further provides a display. The display may specifically include a time sequence drive circuit, a time sequence switch circuit, and a plurality of gate lines. The time sequence drive circuit is configured to provide a scanning signal based on a received drive signal. Specifically, when receiving a frame start signal, the time sequence drive circuit starts to line-by-line output the scanning signal to each gate line. The time sequence switch circuit is configured to connect or disconnect the time sequence drive circuit to/from the plurality of gate lines based on the received gating signal, to transmit a scanning signal corresponding to a partially refreshed image.

Further, the display may further include a data line disposed in a cross manner with the plurality of gate lines. In addition, a plurality of pixel circuits arranged in an array may be disposed in the display. One line of pixel circuits of the plurality of pixel circuits is connected to one gate line. One column of pixel circuits of the plurality of pixel circuits is connected to one data line. When receiving the scanning signal, the gate line may drive a switch in the pixel circuit to be turned on to display a data signal transmitted by the data line.

The time sequence switch circuit of the display provided in this embodiment of this application may connect or disconnect the time sequence drive circuit to/from the plurality of gate lines based on the gating signal provided by the time sequence gating circuit of the display drive chip, so that only the scanning signal corresponding to the partially refreshed image is sent to the corresponding pixel circuit for refreshing and display, and a partially refreshed area can be flexibly controlled. A size of a partially refreshed display image can be adaptively adapted to without adding a plurality of sets of GOAs to the display, to implement precise partial refresh display of the display, and no additional waste of power consumption is generated.

In an embodiment of this application, a display area in the display receives, at a line level, the data signal generated by the channel drive circuit of the display drive chip. After receiving a frame start signal used as the drive signal, the time sequence drive circuit of the display starts to output the scanning signal line by line. The time sequence switch circuit of the display shields, based on the received line-level selection signal, a scanning signal of an invalid line other than the partially refreshed image, and transmits only a scanning signal of a line that needs to be refreshed. After receiving the scanning signal, the pixel circuit that needs to refresh the line refreshes display content based on the data signal, to complete partial refresh display.

In an embodiment of this application, the plurality of pixel circuits of the display may be arranged in an array. To be specific, the plurality of pixel circuits are arranged in a plurality of lines and a plurality of columns, one line of pixel circuits is connected to a same gate line, and one column of pixel circuits is connected to a same data line. The time sequence drive circuit of the display may include a plurality of cascaded shift registers. An internal structure of the shift register is not limited in this application, and various types of shift registers may be applicable. One of the plurality of shift registers is connected to one line of pixel circuits of the plurality of pixel circuits through the gate line. A scanning signal output by each shift register is further input to an input end of a next shift register. An input end of a first shift register is configured to receive the frame start signal generated by the time sequence control circuit of the display drive chip. The time sequence switch circuit of the display may include a plurality of switches. One of the plurality of switches is connected between one of the plurality of shift registers and a corresponding gate line. In other words, the switch controls whether the connected shift register can transmit the scanning signal to the gate line. After the first shift register receives the frame start signal, the shift register shifts and outputs the scanning signal to the connected gate line and the input end of the next shift register level by level starting from the first shift register. The scanning signal output by each shift register is processed by a switch connected to the time sequence switch circuit, and finally is selected to determine whether the scanning signal can be transmitted to the corresponding gate line.

Specifically, the plurality of switches included in the time sequence switch circuit are controlled by the gating signal, and the switch is switched between an on state and an off state. When the switch is in the on state, a scanning signal output by a shift register connected to the switch may be transmitted to the gate line. When the switch is in the off state, the scanning signal output by the shift register connected to the switch is shielded and is not transmitted to the gate line. For example, the display area of the display may include m lines and n columns of pixel circuits. The display area includes m gate lines and n data lines. The time sequence drive circuit includes m cascaded shift registers. The time sequence switch circuit includes m switches. The channel drive circuit of the display drive chip includes n channels.

In an embodiment of this application, the display may be an OLED display, and a pixel circuit of the display may include a plurality of transistors and a light emitting device driven by the transistors to emit light. Alternatively, the display may be an LCD display, and a pixel circuit of the LCD display may include a switch transistor and a pixel electrode. The foregoing internal structure of the pixel circuit is merely an example for description. The internal structure of the pixel circuit is not limited in this application, and may be used in various displays for line-level scanning.

In an embodiment of this application, a control end of each switch included in the time sequence switch circuit may be connected to a gating control line. The gating control line is configured to transmit a gating signal. The gating signal may be simultaneously input to a control end of each switch, to control all the switches to be simultaneously in an on state or an off state at a moment. A first end of each switch is connected to an output end of a corresponding shift register, and a second end of each switch is connected to a corresponding gate line. Each switch may be specifically a thin film transistor (thin film transistor, TFT). The first end of the switch may be specifically a gate of the thin film transistor, and the second end of the switch may be specifically a source or a drain of the thin film transistor. The second end of the switch may be specifically the drain or the source of the thin film transistor.

In an embodiment of this application, the switches included in the time sequence switch circuit are usually all N-type transistors or all P-type transistors. For example, the switches included in the time sequence switch circuit are all the N-type transistors. The N-type transistor is in an off state at a low level, and is in an on state at a high level. For example, when a second line of pixel circuits and a third line of pixel circuits that are connected to a second line of gate lines and a third line of gate lines need to be refreshed for display, and pixel circuits of other lines do not need to be refreshed for display, a gating signal generated by the time sequence gating circuit generates a corresponding time sequence according to a principle of "shielded at a low level and gated at a high level. The first shift register, a second shift register, a third shift register, and a fourth shift register in the time sequence drive circuit of the display sequentially shift and output a scanning signal. The time sequence of the gating signal is at the high level when the second shift register and the third shift register output the scanning signal. All switches are in an on state. Scanning signals output by the second shift register and the third shift register are transmitted to the second line of gate lines and the third line of gate lines, and the second line of pixel circuits and the third line of pixel circuits can be partially refreshed for display. The time sequence of the gating signal is at the low level when the first shift register and the fourth shift register output the scanning signals. All switches are in an off state. Scanning signals output by the first shift register and the fourth shift register are shielded, and no scanning signal is transmitted on the first line of gate lines and the fourth line of gate lines. A first line of pixel circuits and a fourth line of pixel circuits are not refreshed, and a previous frame of image is retained.

In an embodiment of this application, each switch included in the time sequence switch circuit of the display may be independently disposed between the time sequence drive circuit and the display area.

In another embodiment of this application, the time sequence switch circuit of the display may alternatively be integrated into the time sequence drive circuit. An output end of each shift register in the time sequence drive circuit of the display directly controls, based on a time sequence of a gating signal received at this time, whether to output the scanning signal.

In this embodiment of this application, partial refresh of the display may be precisely controlled at a line level. After each frame of partial refresh, the display may be flexibly divided into a plurality of display areas that adaptively adapt to different frame rates.

According to a third aspect, this application further provides a display apparatus. The display apparatus may specifically include the display drive chip provided in any possible design of the first aspect of this application and the display provided in any possible design of the second aspect of this application. In the display apparatus provided in this embodiment of this application, only a line-level switch needs to be added to the display to form the time sequence switch circuit, and the time sequence gating circuit that controls the time sequence switch circuit is added to the display drive chip. This has little impact on the display and the display drive chip, can implement line-level precise partial refresh display of the display, and can adaptively adapt to a size of the partially refreshed image. In addition, a display image in an invalid area is not processed in the display drive chip, so that power consumption of the display drive chip can be effectively reduced.

The display apparatus provided in embodiments of this application may be used in various terminal devices, for example, may be used in an electronic device such as a smartphone, a tablet computer, or a personal digital assistant (personal digital assistant, PDA). It should be noted that the display apparatus provided in embodiments of this application is intended to include but is not limited to these and any other suitable types of terminal devices.

For technical effect that can be achieved by any possible design of any one of the third aspect, refer to the technical effect that can be achieved by any possible design of the first aspect and the second aspect. Details are not described herein again. These aspects or other aspects of this application are clearer and more comprehensible in descriptions of the following embodiments.

### BRIEF DESCRIPTION OF DRAWINGS

FIG. 1 is a diagram of a structure of a conventional display apparatus;
FIG. 2 is a diagram of another structure of a conventional display apparatus;
FIG. 3 is a diagram of a structure of a display apparatus according to an embodiment of this application;
FIG. 4 is a diagram of a specific structure of a display apparatus according to an embodiment of this application;
FIG. 5 is a diagram of another specific structure of a display apparatus according to an embodiment of this application;
FIG. 6 is a diagram of a signal time sequence of a display apparatus according to an embodiment of this application;
FIG. 7 is a diagram of still another specific structure of a display apparatus according to an embodiment of this application; and
FIG. 8 is a diagram in which a display apparatus adaptively adapts to different frame rates according to an embodiment of this application.

### DESCRIPTION OF EMBODIMENTS

To make the objectives, technical solutions, and advantages of this application clearer, the following further describes this application in detail with reference to the accompanying drawings.

Terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

In addition, same reference numerals in the figures represent same or similar structures. Therefore, repeated description thereof is omitted. Expressions of locations and directions in this application are described by using the accompanying drawings as an example. However, changes may also be made as required, and all the changes fall within the protection scope of this application. The accompanying drawings in this application are merely used to illustrate relative position relationships and do not represent an actual scale.

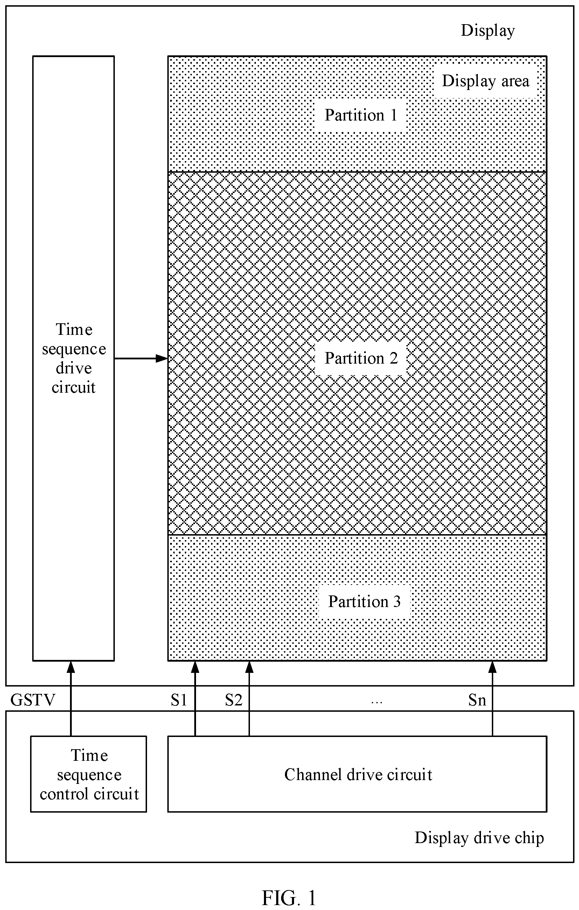

Refer to FIG. 1. Currently, most displays have only one set of time sequence drive circuit (gate driver on array, GOA). As a result, a display drive chip can only splice content that needs to be refreshed and content that does not need to be refreshed into a complete image to drive and display. For example, in FIG. 1, in a frame of image, only content in a partition 2 needs to be refreshed, and content in a partition 1 remains unchanged. Because a display supports only full-screen refresh, the content in the partition 1 that is not refreshed and the content in the partition 2 need to be spliced for drive and display. In this way, a display drive chip needs to perform algorithm processing and drive and display on the content that is in the partition 1 and that is not refreshed. If an area that is not refreshed is large, a large amount of power is consumed.

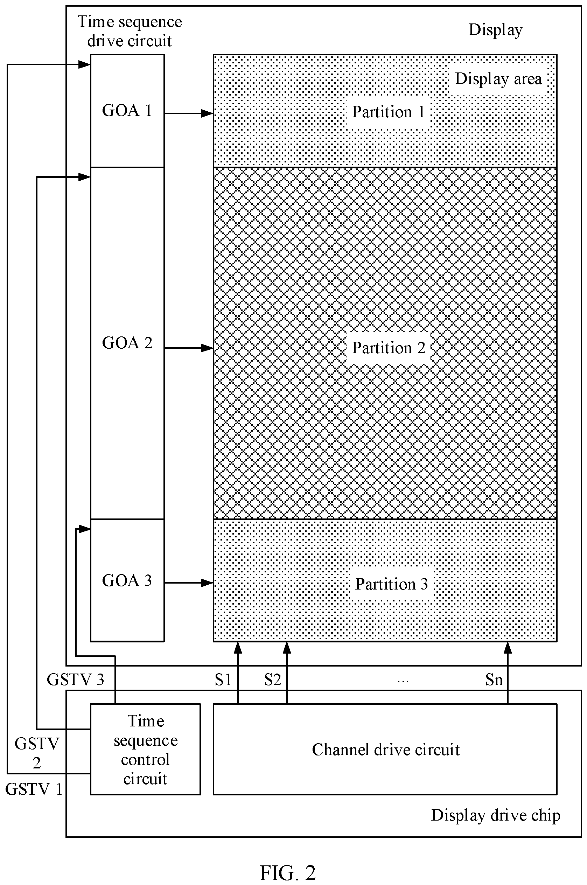

Refer to FIG. 2. To implement a partial refresh function, a conventional solution is to split an original set of time sequence drive circuits into a plurality of mutually independent parts, for example, a GOA 1, a GOA 2, and a GOA 3. The GOA 1 is configured to control a pixel circuit of a fixed partition 1 in a display area to perform refreshing for display. The GOA 2 is configured to control a pixel circuit of a fixed partition 2 in the display area to perform refreshing for display. The GOA 3 is configured to control a pixel circuit of a fixed partition 3 in the display area to perform refreshing for display. A time sequence control circuit of a display drive chip separately sends independent frame start signals GSTV 1, GSTV 2, and GSTV 3 to the GOA 1, the GOA 2, and the GOA 3. When a partial image that needs to be refreshed falls within a partition, the display drive chip refreshes only content of the partition, and content of other partitions remains unchanged. For example, if the partial image that needs to be refreshed falls within the partition 1, the display drive chip drives the GOA 1 to refresh the content in the partition 1. In this case, a channel drive circuit of the display drive chip needs to provide only a data signal corresponding to the partition 1. If a part of the partial image that needs to be refreshed falls in the partition 1, and the other part falls in the partition 2, the display drive chip needs to drive both the GOA 1 and the GOA 2 to refresh the content in the partition 1 and the partition 2. In this case, the channel drive circuit of the display drive chip needs to provide only data signals corresponding to the partition 1 and the partition 2. If full-screen refreshing for display are required, the display drive chip needs to drive all of the GOA 1, the GOA 2, and the GOA 3 to refresh content in all display areas. In this case, the channel drive circuit of the display drive chip needs to provide data signals corresponding to all the partitions.

In the foregoing partial refresh manner, each partition that can be independently refreshed is a fixed area. Consequently, an area that can be partially refreshed is not flexible enough. If the partial image that needs to be refreshed does not occupy an entire partition, another area that does not need to be refreshed in the partition further needs algorithm processing and drive and display, resulting in an additional waste of power consumption. In addition, a plurality of frame start signals that match a plurality of sets of GOAs need to be added to the display drive chip, and more drive power is consumed. If a load of each GOA in the display is heavy, additional power consumption of the GOA may be greater than power consumption saved by a data signal that does not need to be driven by the channel drive circuit. Consequently, power consumption increases without decreasing.

To resolve problems in the conventional technology such as inflexible partial refresh, waste of extra power consumption during partial refresh, and power consumption increases without decreasing, structures of a display drive chip, a display, and a display apparatus are improved in embodiments of this application.

The following describes in detail the display drive chip, the display, and the display apparatus provided in this application with reference to the accompanying drawings.

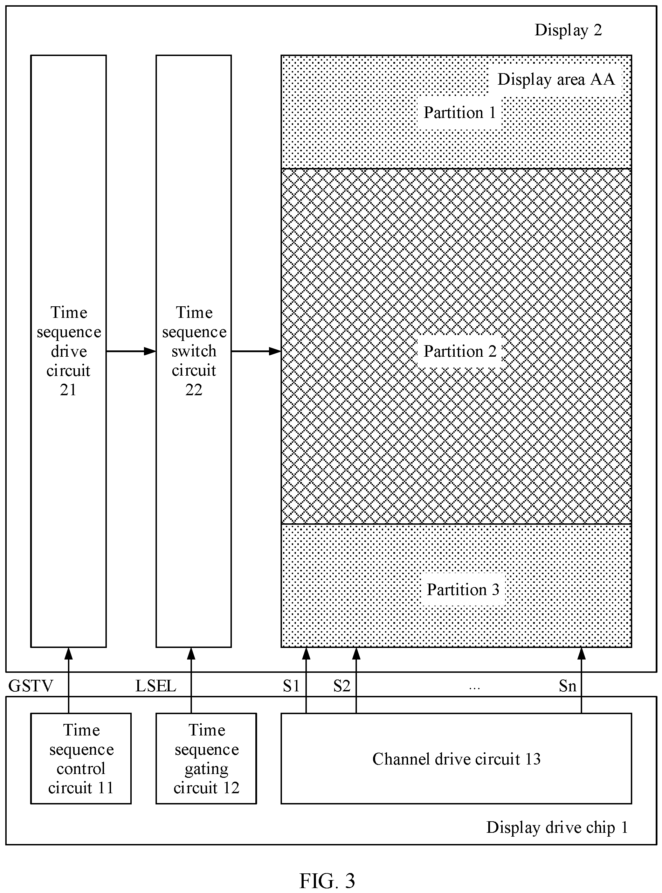

For example, FIG. 3 is a diagram of a structure of a display apparatus according to an embodiment of this application.

Refer to FIG. 3. The display apparatus provided in this embodiment of this application includes a display drive chip 1 and a display 2. The display drive chip 1 is configured to drive the display 2. Based on a structure of a conventional display apparatus, a time sequence gating circuit 12 is added to the display drive chip 1, and a time sequence switch circuit 22 is added to the display 2. The display apparatus provided in embodiments of this application may be used in various terminal devices, for example, may be used in an electronic device such as a smartphone, a tablet computer, or a personal digital assistant (personal digital assistant, PDA). It should be noted that the display apparatus provided in embodiments of this application is intended to include but is not limited to these and any other suitable types of terminal devices.

The display drive chip 1 provided in this embodiment of this application may include a time sequence control circuit 11 and the time sequence gating circuit 12. Correspondingly, the display 2 provided in this embodiment of this application may include a time sequence drive circuit 21, the time sequence switch circuit 22, and a plurality of gate gate lines (not shown in FIG. 3) disposed in a display area AA.

The time sequence control circuit 11 in the display drive chip 1 provided in this embodiment of this application is specifically configured to provide a drive signal for the time sequence drive circuit 21 in the display 2. Specifically, the time sequence control circuit 11 may generate a frame start signal GSTV as a drive signal, and send the drive signal to the time sequence drive circuit 21 in the display 2, to trigger the time sequence drive circuit 21 to start to output a scanning signal level by level. In some other embodiments, the drive signal may alternatively include another type of signal, and is not limited to the frame start signal. The time sequence gating circuit 12 in the display drive chip 1 is specifically configured to provide a gating signal LSEL for the time sequence switch circuit 22 of the display 2. Specifically, the time sequence gating circuit 12 may generate a corresponding gating signal LSEL based on a received partially refreshed image, and send the gating signal LSEL to the time sequence switch circuit 22 of the display 2. The time sequence switch circuit 22 connects or disconnects the time sequence drive circuit 21 and the plurality of gate lines based on the gating signal LSEL. In other words, the time sequence switch circuit 22 may transmit the scanning signal corresponding to the partially refreshed image. Further, the display drive chip 1 may further include a channel drive circuit 13. The channel drive circuit 13 is configured to separately provide a data signal for a plurality of data lines of the display.

Correspondingly, the time sequence drive circuit 21 in the display 2 provided in this embodiment of this application is specifically configured to generate a scanning signal based on the received drive signal. Specifically, when receiving the frame start signal GSTV, the time sequence drive circuit 21 starts to output the scanning signal line-by-line to each gate line. The time sequence switch circuit 22 of the display 2 is specifically configured to connect or disconnect the time sequence drive circuit to/from the plurality of gate lines based on the received gating signal LSEL, to transmit a scanning signal corresponding to the partially refreshed image. Further, the display 2 may further include a data line disposed in a cross manner with the plurality of gate lines. In addition, a plurality of pixel circuits arranged in an array may be disposed in the display. One line of pixel circuits of the plurality of pixel circuits is connected to one gate line. One column of pixel circuits of the plurality of pixel circuits is connected to one data line. When receiving the scanning signal, the gate line may drive a switch in the pixel circuit to be turned on to display a data signal transmitted by the data line.

The time sequence switch circuit 22 of the display drive chip 1 provided in this embodiment of this application can provide the gating signal LSEL for the time sequence switch circuit 22 of the display 2 based on the partially refreshed image. The time sequence switch circuit 22 of the display 2 may connect or disconnect the time sequence drive circuit to/from the plurality of gate lines based on the gating signal LSEL, so that only a scanning signal corresponding to the partially refreshed image is sent to a corresponding pixel circuit for refreshing and display, and a partially refreshed area can be flexibly controlled. A size of a partially refreshed display image can be adaptively adapted to without adding a plurality of sets of GOAs, to implement precise partial refresh display of the display 2, and no additional waste of power consumption is generated.

The channel drive circuit 13 in the display drive chip 1 provided in this embodiment of this application may generate only a data signal corresponding to the gating signal, that is, perform algorithm processing and driving only on the partially refreshed image, so that power consumption of the display drive chip 1 can be effectively reduced. Further, the channel drive circuit 13 may directly process invalid line data other than the partially refreshed image into a vertical blanking area, to disable channel drive and reduce power consumption. In this way, the display drive chip 1 does not need to perform algorithm processing and driving on 1 the invalid data, so that power consumption can be reduced.

The time sequence gating circuit 12 of the display drive chip 1 provided in this embodiment of this application may generate a line-level selection signal (line select) as the gating signal LSEL by using a line of pixel circuits of the display 2 as a unit, and notify the display 2 to implement line-level partial refresh by using the line of pixel circuits as the unit. In other words, the line of pixel circuits of the display 2 is used as a whole, to refresh and display or keep content unchanged. For example, it is assumed that an image that needs to be refreshed for display is a rectangle, coordinates of the partially refreshed image received by the display drive chip 1 are (x1, y1) to (x2, y2), (x1, y1) are coordinates of an upper left corner of the image that needs to be refreshed for display, and (x2, y2) are coordinates of a lower right corner of the image that needs to be refreshed. In this case, the line-level selection signal generated by the time sequence gating circuit 12 based on x1 and x2 is the gating signal LSEL that is in a scanning time period corresponding to lines x1 to x2 and that allows the scanning signal to pass through. Specifically, the channel drive circuit 13 in the display drive chip 1 transmits the generated data signal to a data line of the display area AA in the display 2 in a line level. The time sequence control circuit 11 in the display drive chip 1 sends the frame start signal GSTV to the display 2, to trigger the time sequence drive circuit 21 to start to output the scanning signal line by line. After generating the line-level selection signal, the time sequence gating circuit 12 of the display drive chip 1 notifies the time sequence switch circuit 22 of the display 2 to perform line-level partial refresh. The time sequence switch circuit 22 shields, based on the received line-level selection signal, a scanning signal of an invalid line other than the partially refreshed image, and transmits only a scanning signal of a line that needs to be refreshed. After receiving the scanning signal, the pixel circuit that needs to refresh the line refreshes display content based on the data signal, to complete partial refresh display.

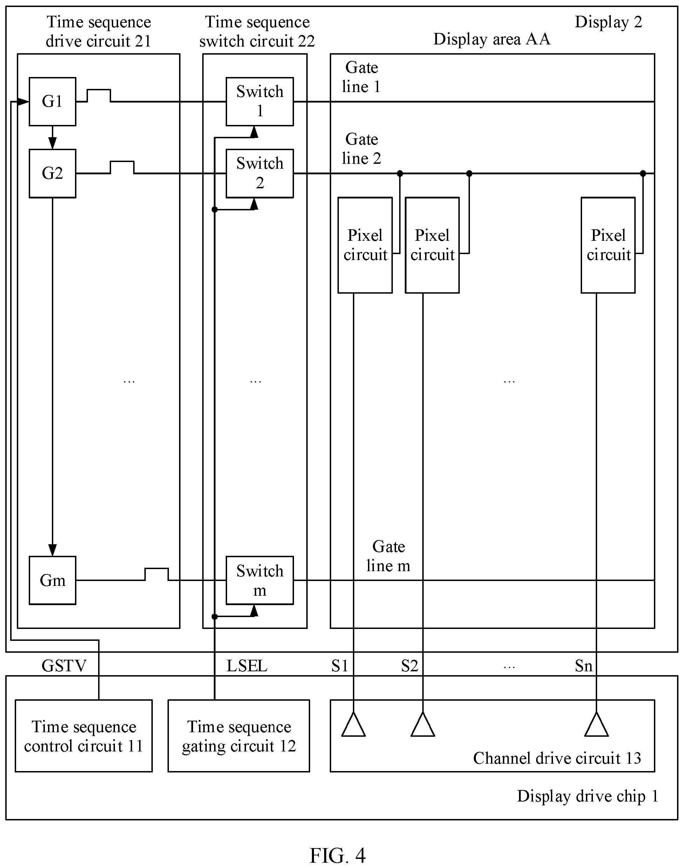

For example, FIG. 4 is a diagram of a specific structure of a display apparatus according to an embodiment of this application.

Refer to FIG. 4. In an embodiment of this application, the plurality of pixel circuits of the display 2 may be arranged in an array. To be specific, the plurality of pixel circuits are arranged in a plurality of lines and a plurality of columns, one line of pixel circuits is connected to a same gate line, and one column of pixel circuits is connected to a same data line. The time sequence drive circuit 21 of the display 2 may include a plurality of cascaded shift registers. An internal structure of the shift register is not limited in this application, and various types of shift registers may be applicable. One of the plurality of shift registers is connected to one line of pixel circuits of the plurality of pixel circuits through the gate line. A scanning signal output by each shift register is further input to an input end of a next shift register. An input end of a first shift register is configured to receive a drive signal, namely, a frame start signal GSTV, provided by the time sequence control circuit 11 of the display drive chip 1. The time sequence switch circuit 22 of the display 2 may include a plurality of switches. One of the plurality of switches is connected between one of the plurality of shift registers and a corresponding gate line. In other words, the switch controls whether the connected shift register can transmit the scanning signal to the gate line. After the first shift register receives the frame start signal GSTV, the shift register shifts and outputs the scanning signal to the connected gate line and the input end of the next shift register level by level starting from the first shift register. The scanning signal output by each shift register is processed by a switch connected to the time sequence switch circuit 22, and finally is selected to determine whether the scanning signal can be transmitted to the corresponding gate line.

Specifically, the plurality of switches included in the time sequence switch circuit 22 are controlled by the gating signal LSEL, and the switch is switched between an on state and an off state. When the switch is in the on state, a scanning signal output by a shift register connected to the switch may be transmitted to the gate line. When the switch is in the off state, the scanning signal output by the shift register connected to the switch is shielded and is not transmitted to the gate line. For example, the display area AA of the display 2 may include m lines and n columns of pixel circuits. The display area AA includes m gate lines and n data lines. The time sequence drive circuit 21 includes m cascaded shift registers. The time sequence switch circuit 22 includes m switches. The channel drive circuit 13 of the display drive chip includes n channels. FIG. 4 shows some pixel circuits arranged in a second line, a first shift register G1, a second shift register G2, a last shift register Gm, a first switch 1, a second switch 2, and a last switch m. The first switch 1 is connected between the first shift register G1 and the first line of gate lines gate 1. The second switch 2 is connected between the second shift register G2 and the second line of gate lines gate 2. The last switch m is connected between the last shift register Gm and the last line of gate lines gate m. FIG. 4 further shows a first channel S1, a second channel S2, and a last channel Sn in the channel drive circuit 13, and each data signal for transmitting a line of pixel circuits of each channel at a same moment.

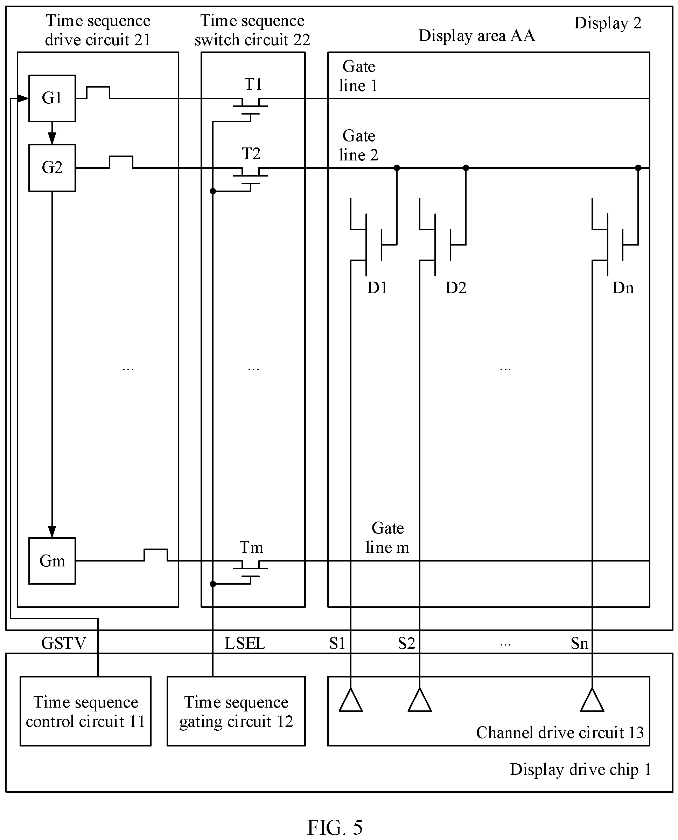

For example, FIG. 5 is a diagram of another specific structure of a display apparatus according to an embodiment of this application.

During specific implementation, the display 2 may be an OLED display, and a pixel circuit of the display may include a plurality of transistors and a light emitting device driven by the transistors to emit light. Alternatively, the display 2 may be an LCD display, and a pixel circuit of the display 2 may include a switch transistor and a pixel electrode. The following uses the LCD display as an example for description. FIG. 5 shows switch transistors D1, D2, ..., and Dn included in some pixel circuits arranged in the second line. Gates of switch transistors in a line are connected to a same gate line. A source (or drain) of each switch transistor is connected to a corresponding data line. The drain (or source) of each switch transistor is connected to a corresponding pixel electrode (not shown). The foregoing internal structure of the pixel circuit is merely an example for description. The internal structure of the pixel circuit is not limited in this application, and may be used in various displays for line-level scanning.

Refer to FIG. 5. In an embodiment of this application, a control end of each switch included in the time sequence switch circuit 22 may be connected to a gating control line. The gating control line is configured to transmit a gating signal LSEL. The gating signal LSEL may be simultaneously input to a control end of each switch, to control all the switches to be simultaneously in an on state or an off state at a moment. A first end of each switch is connected to an output end of a corresponding shift register, and a second end of each switch is connected to a corresponding gate line. For example, refer to FIG. 5. A first end of the first switch 1 is connected to an output end of the first shift register G1. A second end of the first switch 1 is connected to the first line of gate lines gate 1. A first end of the second switch 2 is connected to an output end of the second shift register G2. A second end of the second switch 2 is connected to the second line of gate lines gate 2. A first end of the last switch m is connected to an output end of the last shift register Gm. A second end of the last switch m is connected to the last line of gate lines gate m. Each switch may be specifically a thin film transistor (thin film transistor, TFT). The first end of the switch may be specifically a gate of the thin film transistor, and the second end of the switch may be specifically a source or a drain of the thin film transistor. The second end of the switch may be specifically the drain or the source of the thin film transistor.

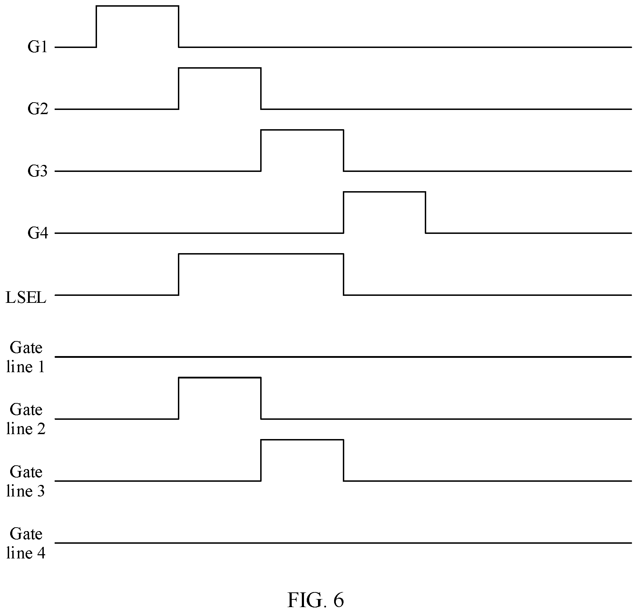

For example, FIG. 6 is a diagram of a signal time sequence of a display apparatus according to an embodiment of this application.

In an embodiment of this application, the switches included in the time sequence switch circuit 22 are usually all N-type transistors or all P-type transistors. For example, the switches included in the time sequence switch circuit 22 are all the N-type transistors. The N-type transistor is in an off state at a low level, and is in an on state at a high level. Refer to FIG. 6. For example, when a second line of pixel circuits and a third line of pixel circuits that are connected to a second line of gate lines gate 2 and a third line of gate lines gate 3 need to be refreshed for display, and pixel circuits of other lines do not need to be refreshed for display, a gating signal LSEL generated by the time sequence gating circuit 12 generates a corresponding time sequence according to a principle of "shielded at a low level and gated at a high level". The first shift register G1, a second shift register G2, a third shift register G3, and a fourth shift register G4 in the time sequence drive circuit 21 of the display 2 sequentially shift and output a scanning signal. The time sequence of the gating signal LSEL is at the high level when the second shift register G2 and the third shift register G3 output the scanning signal. All switches are in an on state. Scanning signals output by the second shift register G2 and the third shift register G3 are transmitted to the second line of gate lines gate 2 and the third line of gate lines gate 3, and the second line of pixel circuits and the third line of pixel circuits can be partially refreshed for display. The time sequence of the gating signal LSEL is at the low level when the first shift register G1 and the fourth shift register G4 output the scanning signals. All switches are in an off state. Scanning signals output by the first shift register G1 and the fourth shift register G4 are shielded, and no scanning signal is transmitted on the first line of gate lines gate 1 and the fourth line of gate lines gate 4. A first line of pixel circuits and a fourth line of pixel circuits are not refreshed, and a previous frame of image is retained.

Refer to FIG. 5. In an embodiment of this application, each switch included in the time sequence switch circuit 22 of the display 2 may be independently disposed between the time sequence drive circuit 21 and the display area AA.

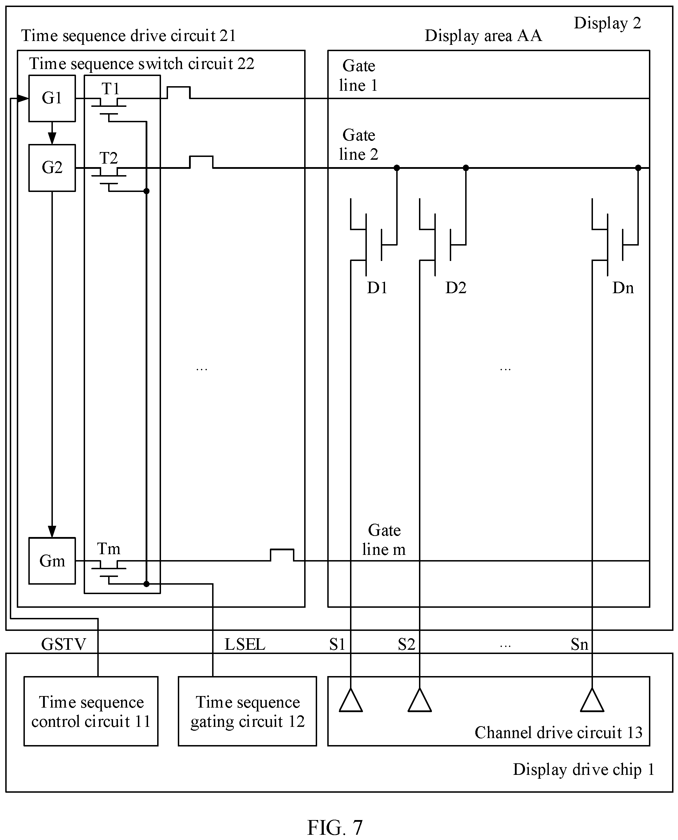

For example, FIG. 7 is a diagram of still another specific structure of a display apparatus according to an embodiment of this application.

Refer to FIG. 7. In another embodiment of this application, the time sequence switch circuit 22 of the display 2 may alternatively be integrated into the time sequence drive circuit 21. An output end of each shift register in the time sequence drive circuit 21 of the display 2 directly controls, based on a time sequence of a gating signal LSEL received at this time, whether to output the scanning signal.

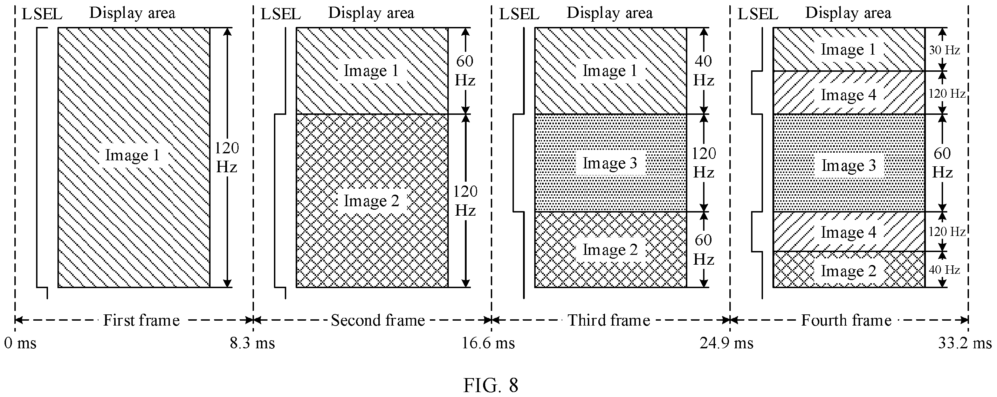

For example, FIG. 8 is a diagram in which a display apparatus adaptively adapts to different frame rates according to an embodiment of this application.

Refer to FIG. 8. The display apparatus provided in this embodiment of this application may accurately control partial refresh of the display 2 at a line level. After each frame of partial refresh, the display 2 may be flexibly divided into a plurality of display areas that adaptively adapt to different frame rates. For example, in FIG. 8, an image 1 in a first frame is refreshed in full screen at 120 Hz. In a second frame, partial refresh is performed only in an area of an image 2, that is, the image 2 is partially refreshed at 120 Hz. An area of the image 1 that does not need to be refreshed is shielded by using the gating signal LSEL, and a frame rate of the image 1 is reduced to 60 Hz. In a third frame, partial refresh is performed only in an area of an image 3, that is, the image 3 is partially refreshed at 120 Hz. Areas of the image 1 and the image 2 that do not need to be refreshed are shielded by using the gating signal LSEL and are not refreshed. In this way, the frame rate of the image 1 is reduced to 40 Hz, the frame rate of the image 2 is reduced to 60 Hz. In the fourth frame, partial refresh is performed only in an area of an image 4, that is, the image 4 is partially refreshed at 120 Hz, and areas of the image 1, the image 2, and the image 3 are shielded by using the gating signal LSEL and are not refreshed. In this way, the frame rate of the image 1 is reduced to 30 Hz, the frame rate of the image 2 is reduced to 40 Hz, and the frame rate of the image 3 is reduced to 60 Hz.

In the display apparatus provided in this embodiment of this application, only a line-level switch needs to be added to the display 2 to form the time sequence switch circuit 22, and the time sequence gating circuit 12 that controls the time sequence switch circuit 22 is added to the display drive chip 1. This has little impact on the display 2 and the display drive chip 1, can implement line-level precise partial refresh display of the display 2, and can adaptively adapt to a size of the partially refreshed image. In addition, a display image in an invalid area is not processed in the display drive chip 1, so that power consumption of the display drive chip can be effectively reduced.

It is clearly that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. A display drive chip, wherein the display drive chip is configured to drive a display, and the display drive chip comprises a time sequence control circuit and a time sequence gating circuit;
the time sequence control circuit is configured to provide a drive signal for a time sequence drive circuit of the display; and
the time sequence gating circuit is configured to provide a gating signal for a time sequence switch circuit of the display, and the time sequence switch circuit is configured to connect or disconnect the time sequence drive circuit to/from a plurality of gate lines of the display based on the gating signal.

2. The display drive chip according to claim 1, further comprising a channel drive circuit, wherein the channel drive circuit is configured to separately provide a data signal for a plurality of data lines of the display.

3. A display, comprising a time sequence drive circuit, a time sequence switch circuit, and a plurality of gate lines, wherein the time sequence switch circuit is connected between the time sequence drive circuit and the gate line;
the time sequence drive circuit is configured to provide a scanning signal based on a drive signal; and
the time sequence switch circuit is configured to connect or disconnect the time sequence drive circuit to/from the plurality of gate lines based on a gating signal.

4. The display according to claim 3, wherein the time sequence drive circuit comprises a plurality of cascaded shift registers, and one of the plurality of shift registers is connected to one of the plurality of gate lines; and
the time sequence switch circuit comprises a plurality of switches, and one of the plurality of switches is connected between one of the plurality of shift registers and a corresponding gate line.

5. The display according to claim 4, further comprising a gating control line, wherein
the gating control line is separately connected to control ends of the plurality of switches, a first end of the switch is connected to an output end of the shift register, and a second end of the switch is connected to the gate line; and
the gating control line is configured to transmit the gating signal.

6. The display according to claim 4 or 5, wherein the plurality of switches are all N-type transistors or all P-type transistors.

7. The display according to any one of claims 4 to 6, wherein the time sequence switch circuit is integrated into the time sequence drive circuit, or the time sequence switch circuit is located between the time sequence drive circuit and the plurality of gate lines.

8. The display according to any one of claims 4 to 7, further comprising a plurality of data lines, wherein the plurality of data lines and the plurality of gate lines are disposed in a cross manner.

9. The display according to claim 8, further comprising a plurality of pixel circuits, wherein one line of pixel circuits of the plurality of pixel circuits is connected to one of the gate lines, and one column of pixel circuits of the plurality of pixel circuits is connected to one of the data lines.

10. A display apparatus, comprising a display drive chip and a display, wherein the display drive chip comprises a time sequence control circuit and a time sequence gating circuit, the display comprises a time sequence drive circuit, a time sequence switch circuit, and a plurality of gate lines, and the time sequence switch circuit is connected between the time sequence drive circuit and the gate line;
the time sequence control circuit is configured to provide a drive signal for the time sequence drive circuit of the display;
the time sequence gating circuit is configured to provide a gating signal for the time sequence switch circuit of the display;
the time sequence drive circuit is configured to provide a scanning signal based on the drive signal; and
the time sequence switch circuit is configured to connect or disconnect the time sequence drive circuit to/from the plurality of gate lines based on the gating signal.
